# EUROPEAN PATENT SPECIFICATION

(11) **EP 0 634 499 B1**
(45) Date of publication and mention of the grant of the patent: **16.09.1998**
(21) Application number: 94110209.7
(22) Date of filing: 30.06.1994
(51) Int. Cl.: C23C 14/34

(54) **Mosaic sputtering target**
Mosaik-Zerstäubungs-Target
Cible de mosaique pour la pulvérisation cathodique

(30) Priority: 15.07.1993 JP 196712/93
(43) Date of publication of application: 18.01.1995
(73) Proprietor: JAPAN ENERGY CORPORATION, Minato-ku, Tokyo (JP)
(72) Inventor: Ohhashi, Tateo, Japan Energy Corporation, Kitaibaraki-shi, Ibaraki-ken (JP); Nakashima, Koichi, Japan Energy Corporation, Kitaibaraki-shi, Ibaraki-ken (JP); Fukuyo, Hideaki, Japan Energy Corporation, Kitaibaraki-shi, Ibaraki-ken (JP); Seki, Takakazu, Japan Energy Corporation, Kitaibaraki-shi, Ibaraki-ken (JP)
(74) Representative: Schwan, Gerhard, Dipl.-Ing.

(56) References cited:
- EP-A- 0 281 141
- EP-A- 0 342 894
- EP-A- 0 500 031
- EP-A- 0 535 314
- US-A- 5 190 630

## Description

### [FIELD OF THE INVENTION]

This invention relates to a mosaic target composed of a plurality of pieces, and more specifically to a mosaic target in which the target pieces are solid-state bonded at the abutted interface of the adjacent target pieces.

### [BACKGROUND OF THE INVENTION]

Targets are usually disk or rectangular shaped plates, which serve as sources of substances to be sputtered on substrates to form thereon electrodes, gates, conductor lines, elements, insulating films, protective films and the like of various semiconductor devices. As accelerated ions impinge on a target surface, the atoms constituting the target are partly released by momentum exchange from the target surface to the ambient space to deposit on an oppositely located substrate. Typical sputtering targets in use include the targets made of Al and Al alloys, refractory metals and their alloys (W, Mo, Ti, Ta, Zr, Nb, etc. and their alloys such as W-Ti), and metal silicides (MoSiₓ, WSiₓ, NiSiₓ etc.).

Generally, targets of two or more different elements are made by alloying or compounding those elements by melting or powder metallurgy. Where a target of good quality is not obtained by these methods because of the density, composition, oxygen concentration, or other problem, the adoption of a mosaic target system is often an alternative. The mosaic target system is realized, when a target is to be formed of two or more elements, by working the materials of individual elements or their alloys or compounds to suitable shapes and appropriately combining and arranging them to form altogether a disk or rectangular plate as a target of a desired composition. The target thus combined and arranged is called a mosaic target. In the mosaic target, the appropriately shaped bulks or plates of each element or its alloy or compound which constitute the structural units and are arranged in abutted relation with adjacent unit(s) is called as (target) pieces. For example, in a Ta-Mo mosaic target, Ta pieces and Mo pieces are alternately combined and arranged in a striped pattern or a radial pattern.

Examples of mosaic targets, besides the Ta-Mo target, are targets of alloys of refractory metals such as Ta-W, Ta-Ti and W-Ti, and silicide targets.

Conventional mosaic targets are fabricated by putting the component pieces abutted together and bonding them in that abutted state to a backing plate with the use of a solder, namely a brazing metal such as In or the like or by shrink fitting them directly on and into a backing plate. In either case, gaps of several to several hundred microns are formed among the adjacent pieces at their abutted interfaces. The gaps can cause abnormal discharge, localized acceleration of sputtering rate that induces particle generation, or concurrent sputtering of the solder or backing plate, leading to contamination and deterioration of the characteristics of the resulting sputtered film.

The problem of concurrent sputtering is described in EP-A-0 342 894, where a solution is proposed involving interposing a thin sheet of material containing one or more of the constituent elements of the target pieces between the latter and the backing plate.

The term "particles" as used herein means the particulate matter that scatters within a film forming apparatus during thin film formation by sputtering and deposit in clusters on a substrate in the apparatus. The clustered particles often grow to sizes as large as several microns across. Their deposition on a substrate can cause problems, e.g., shorting or breaking of conductor lines in large-scale integrated circuits, resulting in an increased percentage of rejects. These particles originate from the particulate matters released from the target.

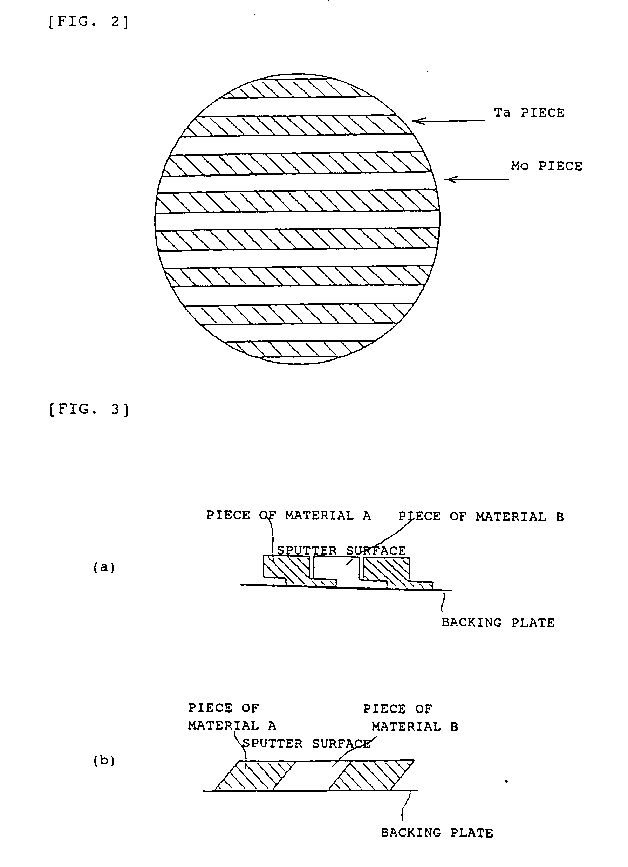

To avoid concurrent sputtering of the solder or backing plate, methods of working the pieces so that their abutting interface profiles are stepped or slanted as at (a) and (b), respectively, in FIG. 3. Here the pieces of materials A and B are alternately combined with their stepped or slanted interfaces in an abutted relation and bonded to a backing plate so that the backing plate and the solder are concealed from the surface to be sputtered. However, these approaches still are unable to control abnormal discharge and particle generation. Moreover, the additional working of the abutted interfaces of target pieces reduce the yield, and in the targets that use expensive materials the material cost increases, and further, working cost is expensive too. In some target materials, even such additional working is difficult to perform.

A sputtering target of a magnetic platinum-cobalt alloy is known from EP-A-0 535 314 whose target pieces are joining together by fusion in order to avoid gaps between the pieces.

### [OBJECT OF THE INVENTION]

The object of this invention is to develop a mosaic target which precludes the possibility of abnormal discharge or particle generation due to gaps at the abutted interfaces of mosaic target pieces, which are of different materials and which does not require unwanted and superfluous working of the target material.

### [SUMMARY OF THE INVENTION]

It has now been found that the above-mentioned problems can be solved by solid-state bonding, e.g., by hot isostatic pressing (HIP), hot pressing, or explosive welding, of the adjacent target pieces of a mosaic target. On the basis of this discovery, this invention provides a mosaic target composed of a plurality of pieces characterized in that the pieces are solid-state bonded at the abutted interface of adjacent pieces.

Solid-state bonding of the pieces at their abutted interfaces eliminates gaps between the adjacent pieces and averts abnormal discharge due to the gaps and also the contamination of the resulting film as a result of concurrent sputtering of a solder or backing plate. By the term "solid-state bonding" is meant any of the methods in which solid materials are brought into contact state and a suitable pressure is applied at a suitable temperature to induce the diffusion of atoms across and along the abutted interface, generation of interatomic forces, etc. to thereby bond or join the solid pieces together. A mosaic target of a unitary structure is obtained by eliminating gaps among the pieces substantially without the sacrifice of the properties of the individual target pieces.

Preferably, a first kind of target pieces of a first material and a second kind of target pieces of a second material are alternately arranged in a radial pattern or superposed in alternate layers and bonded at their abutted interfaces by solid-state bonding, such as HIP or hot pressing, and the solid-state bonded mosaic target blank is machined to a target which is bonded to a backing plate with the use of a solder.

### [BRIEF EXPLANATION OF THE DRAWINGS]

Fig. 1 illustrates examples of target piece arrangement and pressure application wherein (a) shows segmental block pieces of two different materials alternately arranged in a radial pattern and bonded together by solid phase with HIP into a composite target blank in the form of a right rod or cylinder and (b) shows another composite target blank formed of flat plate pieces of two different materials, superposed in alternate layers and bonded by solid phase bonding with hot pressing.

Fig. 2 is a top view of a Ta-Mo mosaic target used in a example of the invention.

Fig. 3 shows how the abutted interfaces of conventional target pieces were profiled and arranged wherein (a) shows stepped abutted interfaces and (b) shows slanted abutted interfaces.

### [DETAILED EXPLANATION OF EMBODIMENTS]

This invention is directed to targets of alloys of refractory metals (alloys of W, Mo, Ti, Ta, Zr, Nb etc.), targets of metal silicides (MoSiₓ, WSiₓ, NiSiₓ etc.), targets of intermetallic compounds etc.. This invention is particularly applicable to cases where targets of favorable properties cannot be obtained by melting or powder metallurgy because of the density, composition, oxygen concentration, or other problems, or to cases where the production by melting process itself is difficult. Cases where this invention is favorably applicable are the fabrication of mosaic targets of refractory metal alloys such as Ta-Mo, Ta-W, Ta-Ti and W-Ti alloys.

As explained above, solid-state bonding refers to any of processes in which solid material pieces held in contact are bonded by the application of a suitable pressure at a suitable temperature. The use of solid-state bonding in the fabrication of a mosaic target makes possible the manufacture of a target of unitary structure free of gaps among the target pieces practically without sacrificing the density, composition, and other properties of those pieces. To constitute an objective mosaic target, the target pieces in the form of blocks or plates of a singular element or its alloy or compound are combined and arranged in abutted state. Solid-state bonding can be accomplished in a variety of ways, including HIP, hot pressing, and explosive welding. The pieces in abutted state at their interfaces can be bonded by holding them at a temperature suited for the target materials, with the application of an appropriate pressure or without load for a given period of time. The bonding temperature varies with the solid-state bonding method used. For example, in the case of solid-state bonding by HIP or hot pressing of a combination of Ta and Mo pieces, the solid-state bonding is achieved at a temperature in the range of 700-2000°C and under a load of 0.5-15 kg/mm²(5-150 MPa). The target blank thus formed by solid-state bonding is then machined to a target of predetermined diameter and thickness.

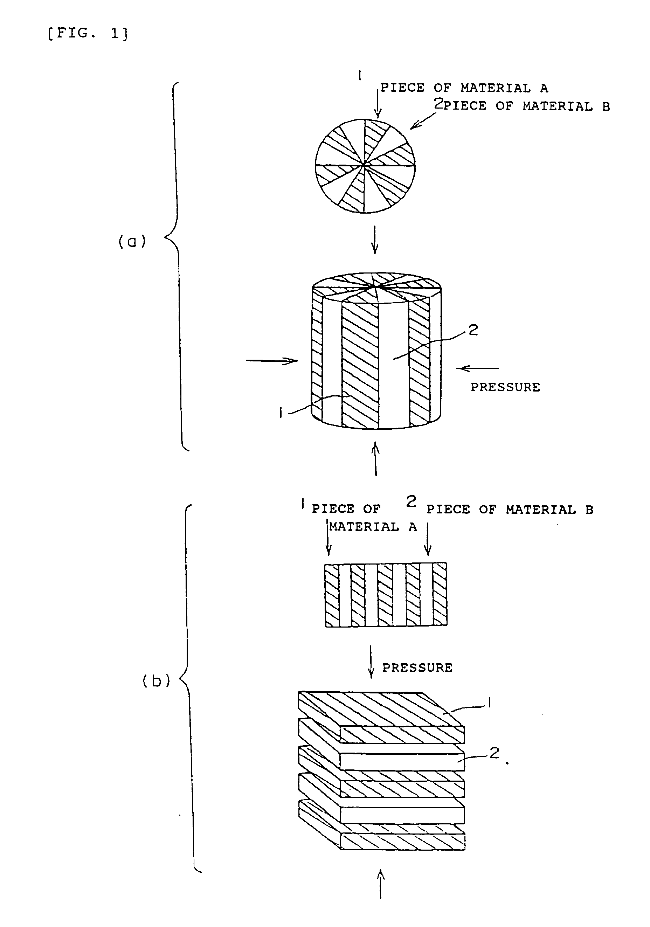

FIG. 1 illustrates examples of target piece arrangement and pressure application. At (a), segmental block pieces 1 of material A and similarly shaped pieces 2 of material B are shown alternately arranged in a radial pattern and bonded together by solid-state bonding, e.g., HIP, into a composite target blank in the form of a right rod or cylinder. Shown at (b) is another composite target blank formed of flat plate pieces 1 of material A and flat plate pieces 2 of material B, superposed in alternate layers and solid-state bonded, e.g., by hot pressing. The solid-bonded target blanks are machined to targets of desired diameter and thickness. The amounts of materials used are by far less than the case of the conventional blanks referred to in Fig. 3.

Generally, a target produced is bonded to a backing plate with the use of a solder such as In.

Depending on the configurations desired for specific applications, the targets need not be made in one piece but may be divided into two or several sections unless the division brings any trouble. In the latter case, because a great majority of the target pieces are bonded at solid-state bonding at their abutted interfaces, it is possible to reduce abnormal discharge and contamination of a solder or backing plate material to almost nil.

### [EXAMPLES]

A 4-in. diameter Ta-Mo mosaic target of 5 mm thickness was produced by arranging Ta pieces (6.5 mm wide) and Mo pieces (6.5 mm wide) in a striped pattern as shown in FIG. 2 and bonding them by solid-state bonding at their abutted interfaces. The mosaic target produced was actually sputtered in a sputtering apparatus and observed for the occurrence of abnormal discharge during sputtering, and then the properties of the film thus formed by sputtering was evaluated.

A mosaic target was assembled from 6.5 mm-thick Ta plates and 6.5 mm-thick Mo plates by superposing them in alternate layers and bonding them in solid state by HIP. The HIP conditions were: temperature = 1400 °C; pressure = 1kg/mm²(10 MPa); and holding time = 1 hr. The composite material blank was machined to a 10.2 cm (4-in.) diameter target. It was confirmed by observation under a scanning electron microscope that there was no gap among the joint portions. This mosaic target was bonded to a Cu backing plate with In solder to make a target assembly.

This target assembly was sputtered under the conditions listed below, and the frequency of abnormal discharge was found to be zero during a sputtering period of 10 minutes. Neither the Cu that constituted the backing plate nor the In that formed the solder was detected from the sputtered film produced on a substrate.

| (Sputtering conditions) | |
|---|---|
| Atmosphere | Ar |
| Pressure | 0.5 Pa |
| Power density | 5 W/cm² |
| Substrate | "Corning 7059" glass |
| Substrate temperature | room temperature |

Simple mosaic targets the pieces of which were merely placed in abutted relation with no solid-state bonded interfaces and bonded to a backing plate with an In solder were used as comparative examples. With those targets abnormal discharge occurred from several times to several ten times. In contaminant from the In solder was detected from the films formed by sputtering, in amounts from several ten to several hundred parts per million. The amounts of particle generation were many, too.

Thus, the solid-state bonding of target pieces at their abutted interfaces ensures the prevention of abnormal discharge and contamination with a solder or backing plate. Hence, it is assured that sputter films with good film qualities can be formed in a stable manner.

### [ADVANTAGES OF THE INVENTION]

The use of a mosaic target according to this invention permits sputtering to be performed in stable conditions without the occurrence of abnormal discharge or particle generation. The resulting sputter film exhibits high film quality with no contamination by a solder or backing plate used. Moreover, there is no need of machining the abutted interfaces of pieces to complex contours as has been necessary heretofore, and the material loss due to machining and the machining cost can be saved.

## Claims

1. A mosaic sputtering target composed of a plurality of target pieces of different materials, said target pieces having been solid-state bonded at their abutted interfaces.

2. The mosaic target of claim 1 wherein the materials of the target pieces are selected from the group consisting of Ta, Mo, Ti, W, Zr, Nb, and their alloys and compounds, and metal silicides.

3. The mosaic target of claim 1 wherein the target pieces are combined in a stripe pattern or in a radial pattern.

## Patentansprüche

1. Mosaik-Sputtering-Target bestehend aus einer Mehrzahl von Targetstücken aus unterschiedlichen Materialien, wobei die Targetstücke an ihren gegeneinander anliegenden Grenzflächen mittels Schweißen im festen Zustand zusammegefügt wurden.

2. Mosaik-Target nach Anspruch 1, wobei die Werkstoffe der Targetstücke aus der aus Ta. Mo, Ti, W, Zr, Nb und deren Legierungen und Verbindungen sowie Metall-Siliziden ausgewählt sind.

3. Mosaik-Target nach Anspruch 1, wobei die Targetstücke in einem Streifenmuster oder in einem Radialmuster miteinander kombiniert sind.

## Revendications

1. Cible de pulvérisation à mosaïque composée de plusieurs pièces de cible de matières différentes, lesdites pièces de cible étant liées dans un état solide par leurs interfaces attenantes.

2. Cible à mosaïque selon la revendication 1, dans laquelle les matières des pièces de la cible sont choisies dans le groupe constitué de Ta, Mo, Ti, W, Zr, Nb et leurs alliages et composés, et de siliciures de métaux.

3. Cible à mosaïque selon la revendication 1, dans laquelle les pièces de la cible sont combinées en un motif à bandes ou en un motif radial.
